Europäisches Patentamt

European Patent Office

Office européen des brevets

(19)

(11) Veröffentlichungsnummer : **0 470 071 B1**

(12) **EUROPÄISCHE PATENTSCHRIFT**

(45) Veröffentlichungstag der Patentschrift :
30.08.95 Patentblatt 95/35

(51) Int. Cl.$^6$ : **G03F 7/32**

(21) Anmeldenummer : 89905678.2

(22) Anmeldetag : 29.04.89

(86) Internationale Anmeldenummer :
**PCT/EP89/00478**

(87) Internationale Veröffentlichungsnummer :
**WO 90/13853 15.11.90 Gazette 90/26**

(54) **Verfahren zur Herstellung von Flexodruckformen.**

(43) Veröffentlichungstag der Anmeldung :
**12.02.92 Patentblatt 92/07**

(45) Bekanntmachung des Hinweises auf die
Patenterteilung :
**30.08.95 Patentblatt 95/35**

(84) Benannte Vertragsstaaten :
**AT SE**

(56) Entgegenhaltungen :
**GB-A- 1 189 944**
**US-A- 3 887 373**
**Patent Abstracts of Japan, vol. 8, No. 278**
**(P-322)(1715), 19 December 1984 & JP-A-59 146**
**054**

(73) Patentinhaber : **BASF Aktiengesellschaft**
**Carl-Bosch-Strasse 38**
**D-67063 Ludwigshafen (DE)**

(72) Erfinder : **TELSER, Thomas**
**Seilerstrasse 26**
**D-6700 Ludwigshafen (DE)**
Erfinder : **KOCH, Horst**
**Tiefenthalerstrasse 47**
**D-6718 Grünstadt (DE)**
Erfinder : **KURTZ, Karl-Rudolf**
**Schloss-Wolfs-Brunnen-Weg 62**
**D-6900 Heidelberg (DE)**
Erfinder : **BACH, Helmut**
**Dahlienstrasse 7**
**D-6704 Mutterstadt (DE)**
Erfinder : **WERTHER, Heinz-Ulrich**
**Hans-Hoffmann-Strasse 12**
**D-6706 Wachenheim (DE)**

EP 0 470 071 B1

## Beschreibung

Die Erfindung betrifft ein Verfahren zur Herstellung von durch Photopolymerisation vernetzten Flexodruckformen, wobei zum Auswaschen der unvernetzten Anteile der Schichten bestimmte Entwicklerlösungsmittel verwendet werden.

Die Herstellung von Flexodruckformen durch bildmäßiges Belichten von photopolymerisierbaren oder photovernetzbaren reliefbildenden Schichten mit aktinischem Licht unter Vernetzung der belichteten Schichtanteile und anschließendes Auswaschen der unvernetzten Anteile der Schichten in Entwicklerlösemitteln ist bekannt. Üblicherweise werden dabei als Entwicklerlösemittel chlorierte Kohlenwasserstoffe wie z.B. Trichlorethylen, Tetrachlorethylen, aromatische Kohlenwasserstoffe wie Benzol, Toluol, gesättigte cyclische und acyclische Kohlenwasserstoffe wie Hexan, Cyclohexan, ungesättigte cyclische Kohlenwasserstoffe wie z.B. terpenoide Verbindungen, Limonen, Pinen, niedere aliphatische Ketone wie Aceton, Methylethylketon, gegebenenfalls im Gemisch mit einem Alkohol (z.B. Butanol mit einem Anteil von ca. 20 Vol.-%) eingesetzt.

Die im Markt vielfach eingesetzte Auswaschlösung für Flexodruckplatten aus etwa 80 Vol.-Teilen Tetrachlorethylen und 20 Vol.-Teilen n-Butanol bzw. Trichlorethan verursacht durch ihre Toxizität Probleme beim Betrieb der Waschgeräte. So ist für einen ordnungsgemäßen Betrieb eine Absaugung notwendig, und die Abluft muß vor der Freisetzung von den chlorierten Kohlenwasserstoffen befreit werden. Auch die Entsorgung der gebrauchten Auswaschlösung gestaltet sich problematisch. Weitere Probleme ergeben sich durch die hohe Quellung, die die belichtete Schicht während des Auswaschens erfährt. Die hohe Quellung der Schicht verursacht Schäden an den photopolymerisierten Strukturen (Ausbrüche, Ablösen feiner Elemente etc.) sowie eine geringe Resistenz gegen Überwaschung.

Dem Einsatz alternativer Auswaschmittel, wie den aromatischen und aliphatischen Kohlenwasserstoffen, stehen Probleme der Brennbarkeit entgegen. Diese Lösemittel weisen Flammpunkte unterhalb 21°C auf und müssten folglich in explosionsgeschützten Anlagen betrieben werden. Das gilt auch für die niedermolekularen Lösemittel aus der Gruppe der Ketone.

Terpenoide Kohlenwasserstoffe, wie z.B. Limonen, besitzen zwar genügend hohe Flammpunkte; ihr Einsatz als Auswaschlösung wird durch ihren intensiven, oft reizenden Geruch eingeschränkt.

Die Verwendung verschiedener Erdölfraktionen, welche wenig Aromaten enthalten und im Handel erhältlich sind, für die Entwicklung von photochemisch vernetzten Photoresisten ist aus der US-A-3 997 373 bekannt. Allerdings werden diese Photoresiste für die Herstellung von Halbleitererzeugnissen, d.h. Microchips, verwendet. Die US-A-3 887 373 bezieht sich somit auf ein technisches Gebiet, welches von dem der vorliegenden Erfindung weit entfernt ist, und liefert dem Fachmann keinerlei Hinweise darauf, wie er durch Photopolymerisation vernetzte Flexodruckformen herstellen und verwenden kann.

Aufgabe der vorliegenden Erfindung war es deshalb, ein Auswaschmittel zu finden, dessen Flammpunkt deutlich über Raumtemperatur liegt, das nur eine geringe Auswaschzeit für Flexodruckplatten benötigt, nur eine geringfügige Quellung der Flexodruckform verursacht, geringe Toxizität sowie nur geringen bzw. angenehmen Geruch aufweist.

Überraschenderweise wurde gefunden, daß diese Eigenschaften mit Auswaschmitteln erfüllt werden können, die als Kohlenwasserstofflösungsmittel bestimmte hydrierte Erdölfraktionen enthalten.

Gegenstand der vorliegenden Erfindung ist ein Verfahren zur Herstellung von durch Photopolymerisation vernetzten Flexodruckformen durch bildmäßiges Belichten von durch Photopolymerisation vernetzbaren Schichten mit aktinischem Licht unter Vernetzung der belichteten Schichtanteile und Auswaschen der unvernetzten Anteile der Schichten mit Kohlenwasserstofflösungsmitteln oder Gemischen aus Kohlenwasserstofflösungsmitteln und Alkoholen, das dadurch gekennzeichnet ist, daß die vernetzbaren Schichten als Bindemittel Vinylaromat/Alkadienblockmischpolymerisate, Alkadien/Acrylnitrilcopolymerisate und/oder Ethylen-Propylen-Dien-Terpolymere enthalten, und zum Auswaschen als Kohlenwasserstofflösungsmittel hydrierte Erdölfraktionen verwendet werden, die Flammpunkte >45°C und Siedebereiche zwischen 160 und 220°C aufweisen.

Die hydrierten Erdölfraktionen haben im allgemeinen einen Aromatengehalt nach DIN 51 378 von <1 %. Bevorzugt sind solche hydrierten Erdölfraktionen, die einen naphthenischen Anteil - ebenfalls nach DIN 51 378 bestimmt - zwischen 0,5 und 50 % aufweisen.

Die erfindungsgemäßen Auswaschmittel können auch Zusätze von Geruchsverbesserern und/oder oberflächenaktiven Stoffe enthalten.

Aromatenhaltige Kohlenwasserstofflösungsmittel (Aromatenanteil >10 %) eignen sich zwar ebenfalls als Auswaschmittel für Druckplatten bzw. Resiste, sie haben aber deutlich niedrigere OEL-Werte und einen unangenehmen Geruch.

Rein paraffinische Lösungsmittel, wie z.B. die synthetischen Isoparaffine, eignen sich dagegen kaum zum Auswaschen von Druckplatten und Resisten. Dasselbe gilt für hochsiedende n-Paraffingemische.

Entaromatisierte Kohlenwasserstofflösungsmittel mit einem Siedebereich oberhalb 230°C sind aufgrund zu hoher Auswaschzeiten ebenfalls nicht als Auswaschmittel für Druckplatten bzw. Resiste geeignet.

Erfindungsgemäß bevorzugte hydrierte Erdölfraktionen sind insbesondere solche, die neben einem Aromatengehalt von <1 % und einem Flammpunkt von >45°C einen Siedebereich von 170 bis 220°C, insbesondere 180 bis 210°C, und einen Anteil an naphthenischen Kohlenwasserstoffen von 0,5 bis 50, insbesondere 10 bis 40 %, (nach DIN 51 378) aufweisen.

Beispiele für geeignete hydrierte Erdölfraktionen sind Shellsol®D 60 der Fa. Shell und Exxsol®D 60 der Fa. Esso, die einen Siedebereich von etwa 180 bis 210°C, einen Flammpunkt von ca. 60°C, einen Aromatengehalt von 0,5 %, sowie einen Gehalt an naphthenischen Kohlenwasserstoffen von ca. 30 % aufweisen. Diese Produkte sind zudem fast vollständig geruchsfrei und weisen hohe OEL-Werte (OEL = occupation1 exposure limit) auf.

Da Flexodruckplatten im allgemeinen einen mehrschichtigen Aufbau besitzen (auf der ca. 3000 μm starken Reliefschicht befindet sich häufig eine dünne, ca. 5 μm starke Deckschicht aus Polyamid), kann es zweckmäßig sein, den erfindungsgemäß einzusetzenden hydrierten Erdölfraktionen eine Alkoholkomponente zuzufügen.

Als geeignet erwiesen sich hierzu Alkohole mit einer Kohlenstoffanzahl von 4 bis 8 (z.B. n-Butanol, n-Pentanol, iso-Butanol, Hexanol u.a.). Um eine ausreichende Löslichkeit der Polyamid-Deckschicht zu gewährleisten, sollte der Anteil der Alkoholkomponente mindestens 5 Vol.%, bevorzugt 20 Vol.%, betragen. Durch die Anwesenheit des Alkohols erniedrigt sich der Flammpunkt des reinen Kohlenwasserstofflösungsmittels um 10 bis 20°C. Die Flammpunkte der formulierten Auswaschlösungen liegen dann bei ca. 40°C. Die Auswaschlösungen können folglich in Geräten ohne EX-Schutz verarbeitet werden.

Wie bereits oben erwähnt, können die Auswaschlösungen noch oberflächenaktive Agentien, die die Auflösung des nicht belichteten Materials beschleunigen, und Anteile von geruchsverbessernden Substanzen enthalten.

Als oberflächenaktive Substanzen kommen beispielsweise Alkylsulfonate und deren Salze, Alkylammoniumsalze oder ethoxylierte Fettalkohole, Fettalkoholethersulfate und ihre Salze sowie Fettalkoholphosphorsäureester und deren Salze in Frage. Die oberflächenaktiven Komponenten können der Auswaschlösung üblicherweise in einer Menge von 0 bis 2 Gew.% zugesetzt werden.

Als geruchsverbessernde Zusatzstoffe kommen beispielsweise die in der Natur vorkommenden terpenoiden Verbindungen, Limonen, Pinen, Citronellol, etc. in Frage. Diese können der Auswaschlösung je nach der gewünschten Intensität des aromatischen Geruchs in einem Anteil von 0 bis max. 10 Gew.%., zugegeben werden.

Das Entwickeln und Auswaschen der bildmäßig belichteten photopolymeren Schichten erfolgt in üblicher Weise in den bekannten Sprüh-, Bürsten- und Reibewaschern bei Temperaturen von 20 bis 50°C. Dabei zeigt es sich, daß die für eine bestimmte Auswaschtiefe notwendige Auswaschzeit im Falle der erfindungsgemäßen Auswaschlösungen nur unwesentlich höher ist als im Falle der gängigen Auswaschmittel, daß aber die Lösungsmittelaufnahme der belichteten Teile der Reliefschicht im Falle der erfindungsgemäßen Auswaschlösungen drastisch verringert wird. Dadurch verbessert sich die Überwaschresistenz der durch bildmäßige Belichtung erzeugten Strukturen ganz erheblich, d.h. auch wenn die für eine bestimmte Reliefhöhe notwendige Auswaschzeit überschritten wird, werden fehlerfreie Strukturen erhalten. Dies ist vor allem bei dünnen Schichten (Stärke <0.7 mm) von Bedeutung, die zunehmend im hochqualitativen Rasterflexodruck eingesetzt werden.

Auch die Ausbruchstabilität der durch bildmäßige Belichtung erzeugten Strukturen wird durch die erfindungsgemäße Verwendung der oben beschriebenen hydrierten Erdölfraktionen erheblich verbessert. Dies ist von besonderer Bedeutung bei dicken weichelastischen Druckplatten mit hohem Relief (ca. 3 mm), die beispielsweise im Kartonagen- und Wellpappendruck eingesetzt werden.

Ein weiterer überraschender Vorteil der erfindungsgemäß einzusetzenden Auswaschlösungen betrifft die Oberflächengüte der bildmäßig belichteten und ausgewaschenen Schichten. Insbesondere beim Auswaschen von Flexodruckplatten in den gängigen Flexolösemitteln kommt es oft zu einer unerwünschten Oberflächenstruktur in Form von Runzeln (die sogenannte Orangenhaut), die beim Auswaschen in den erfindungsgemäßen Lösemitteln nicht beobachtet werden, so daß die erfindungsgemäß hergestellten Reliefformen eine gleichmäßig glatte Oberfläche aufweisen.

Ein weiterer überraschender Vorteil der erfindungsgemäß zu verwendenden Auswaschlösungen ist die Tatsache, daß trotz des hohen Siedebereiches der in Rede stehenden hydrierten Erdölfraktionen im Vergleich zu den Auswaschlösungen mit Tetrachlorethylen keine verlängerten Trocknungszeiten nach dem Auswaschen notwendig sind.

Vorteilhaft ist ferner, daß die Auswaschmittel gemäß vorliegender Erfindung in nicht-explosionsgeschützten Auswaschgeräten eingesetzt werden können. Aufgrund des geringen Eigengeruchs der erfindungsgemäß einzusetzenden hydrierten Erdölfraktionen kann die Absaugung der Auswaschgeräte stark reduziert werden. Nach der Fertigstellung sind die Flexodruckformen geruchlos.

Vorteilhaft ist weiterhin die Tatsache, daß die erfindungsgemäßen Auswaschlösungen an zahlreichen bekannten, durch Photopolymerisation vernetzbaren Schichten mit Erfolg angewandt werden können.

So ergeben sich kurze Auswaschzeiten bei photopolymerisierbaren Schichten, die als Bindemittel Vinylaromat/Alkadienblockmischpolymerisate (Styrol-Isopren-Styrol, Styrol-Butadien-Styrol, Styrol-Isopren-Styrol/Butadien, etc.) enthalten, sowie bei Schichten, die als Bindemittel Alkadien/Acrylnitrilcopolymerisate (Butadien-Acrylnitril), Kurze Auswaschzeiten ergeben sich ferner an Aufzeichnungsmaterialien, die als Bindemittel Ethylen-Propylen-Dien-Terpolymere enthalten.

Die Vorteile der erfindungsgemäßen Auswaschmittel für Flexodruckplatten werden in den folgenden Beispielen und Vergleichsbeispielen erläutert.

Die verwendeten Rohschichten hatten die folgenden Zusammensetzungen (Anteile in Gew.-%)

1. Plattentyp 1 (Einschichtenplatte)

| | |
|---|---|
| 3-Blockkautschuk aus Styrol/Isopren/Styrol-Butadien gemäß EP-A-27 612, Beispiel 2 | 87.592 % |
| Paraffinöl | 5 % |
| Hexandioldiacrylat | 5 % |
| Benzildimethylketal | 1.2 % |
| 2,6-Di-tert.-butyl-p.-kresol | 1.2 % |
| Farbstoff Solvent Black (C.I. 26 150) | 0.008 % |

Schichtstärke 2700 µm auf einer 125 µm starken Polyethylenterephthalatfolie, die mit einem Polyurethanhaftlack beschichtet wurde.

2. Plattentyp 2 (Mehrschichtenplatte)

| | |
|---|---|
| 3-Blockkautschuk wie bei Plattentyp 1 | 93.596 % |
| Hexandioldiacrylat | 5 % |
| Benzildimethylketal | 0.4 % |
| 2,6-Di-tert.-butyl-p-kresol | 1.0 % |
| Farbstoff Solvent Black (C.I. 26 150) | 0.004 % |

Schichtstärke 700 µm auf einer 125 µm starken Polyethylenterephthalatfolie, die mit einem Polyurethanhaftlack beschichtet war. Als Trägerschicht wurde eine photovernetzbare Schicht ebenfalls auf Basis eines elastomeren Bindemittels eingesetzt (Stärke 2000 µm).

3. Plattentyp 3

| | |
|---|---|
| Terpolymer aus Ethylen/Propylen/Ethyliden-norbornen (Anteile 50 % Ethylen; 8 Doppelbindungen je 1000 C-Atome) | 78 % |
| Dioctyladipat | 10 % |
| Dihydrocyclopentadienylacrylat | 6 % |
| Isobornylacrylat | 4 % |
| Benzildimethylketal | 2 % |

Schichtstärke 2700 µm auf einer 125 µm starken Polyethylenterephthalatfolie, die mit einem Polyurethanhaftlack beschichtet wurde.

Beispiel 1

Es wurde eine Flexodruckplatte (Plattentyp 1) in üblicher Weise hergestellt.

Die Flexodruckplatte wurde zunächst während 65 Sekunden von der Rückseite her in einem Röhrenbelichter vollflächig vorbelichtet, anschließend durch eine Negativauflage hindurch stufenweise bildmäßig belichtet (Belichtungszeiten pro Nutzen des Negativs von 6 bis 20 Minuten) und bei Raumtemperatur in einem nicht explosionsgeschützten Bürstenwascher mit geringer Luftabsaugung (ca. 10 m³/h) ausgewaschen. Der Wascher enthielt eine Auswaschlösung aus 80 Vol.-Teilen einer hydrierten Erdölfraktion (Naphthengehalt 35 %, Siedebereich 186 bis 217°C) und 20 Vol.-Teilen n-Butanol.

Für eine gewünschte Reliefhöhe von 700 µm betrug die optimale Auswaschzeit 6 Minuten.

Schon bei 6-minütiger Belichtungszeit waren alle Testelemente der erhaltenen Flexodruckform vollständig und korrekt ausgebildet.

Die Flexodruckform wurde 2 Stunden bei 65°C getrocknet, während 15 Stunden bei Raumtemperatur gelagert, einer üblichen Nachbehandlung mit einer wäßrigen Bromlösung unterzogen und erneut getrocknet.

Die Flexodruckform wies nach der Fertigstellung eine gleichmäßig glatte Oberfläche auf. Es konnte keine Orangenhaut beobachtet werden. Die Druckform war nach der Herstellung geruchlos.

Die nachbehandelte Flexodruckform wurde auf einen Druckzylinder in einem Flexodruckwerk aufgespannt und lieferte ausgezeichnete Druckergebnisse, die keinerlei Informationsverlust gegenüber der Negativvorlage aufwiesen.

Beispiel 2

Es wurde wie in Beispiel 1 verfahren, nur wurde der Auswaschlösung als Alkoholkomponente anstatt n-Butanol n-Pentanol (Anteil 20 Vol.-Teile) zugesetzt. Die Auswaschversuche wurden wiederum in einem nicht explosionsgeschützten Bürstenwascher mit geringer Absaugung (ca. 10 m³/Stunde) durchgeführt.

Die optimale Auswaschzeit betrug 6 Minuten. Alle Testelemente waren schon bei einer Belichtungszeit von 6 Minuten vollständig und korrekt ausgebildet.

Nach der Nachbehandlung wies die Flexodruckform wiederum eine gleichmäßig, glatte Oberfläche und gute Druckeigenschaften auf und war geruchsfrei.

Vergleichsbeispiel 1

Es wurde wie in Beispiel 1 verfahren, nur wurde als Auswaschlösung eine Mischung aus 80 Vol.-Teilen Tetrachlorethylen und 20 Vol.-Teilen n-Butanol verwendet.

Die Auswaschversuche wurden in einem nicht explosionsgeschützten, aber mit einer starken Luftabsaugung (ca. 100 m³/h) versehenen Bürstenwascher durchgeführt.

Die optimale Auswaschzeit betrug 5 Minuten. Die Testelemente waren erst nach einer Belichtungszeit von >12 Minuten fehlerfrei ausgebildet. Bei kürzeren Belichtungszeiten wurden an den Testelementen, insbesondere an Gitter- und Rasterfeldern, Ausbrüche festgestellt.

Nach dem Trocknen und der Nachbehandlung wiesen die Flexodruckformen eine ungleichförmige strukturierte Oberfläche (Orangenhaut) auf.

Vergleichsbeispiel 2

Es wurde wie in Beispiel 1 verfahren, nur wurde als Auswaschlösung eine Mischung aus 80 Vol.-Teilen Testbenzin (Aromatengehalt 25 %, Siedebereich 187 bis 216°C) und 20 Vol.-Teilen n-Butanol eingesetzt. Die Auswaschversuche wurden in einem nicht explosionsgerchützten Wascher mit starker Absaugung (ca. 100 m³/h) durchgeführt.

Die optimale Auswaschzeit betrug 5 Minuten. Die Flexodruckformen besaßen nach ihrer Fertigstellung einen unangenehmen Geruch.

Vergleichsbeispiel 3

Es wurde wie in Beispiel 1 verfahren, nur wurde als Auswaschlösung eine Mischung aus 80 Vol.-Teilen Testbenzin (Aromatengehalt 25 %, Siedebereich 155 bis 185°C) und 20 Vol.-Teilen n-Butanol eingesetzt. Die Versuche wurde in einem explosionsgeschützten Wascher mit starker Absaugung (ca. 100 m³/h) durchgeführt.

Die optimale Auswaschzeit für ein 700 µm Relief betrug 6 Minuten. Die Flexodruckformen besaßen nach ihrer Fertigstellung einen unangenehmen Geruch.

Vergleichsbeispiel 4

Es wurde wie in Beispiel 1 verfahren, nur wurde als Auswaschmittel eine Mischung aus 80 Vol.-Teilen eines hydrierten Mineralöles (Siedebereich 220 bis 255°C naphthenischer Anteil ca. 30 %) und 20 Vol.-Teilen n-Butanol eingesetzt. Die Versuche wurde in einem nicht explosionsgeschützten Bürstenwascher mit geringer Absaugung (ca. 10 m³/h) durchgeführt.

Die Auswaschzeit für ein 700 µm starkes Relief betrug 17 Minuten.

Beispiel 3

Es wurde wie in Beispiel 2 verfahren, nur wurde anstelle des Plattentyps 1 der mehrschichtige Plattentyp 2 mit einer festgelegten Reliefhöhe von 700 µm eingesetzt. Die Versuche wurden in einem nicht explosionsgeschützten Wascher mit geringer Absaugung (ca. 10 m³/h) durchgeführt.

Die optimale Auswaschzeit betrug 6 Minuten. Bei einer 100 %igen Überwaschung, d.h. bei einer gesamten Auswaschzeit von 12 Minuten, konnten keine Schäden an der Reliefstruktur oder fehlende Testelemente beobachtet werden. Die Flexodruckformen waren geruchsfrei.

Vergleichsbeispiel 5

Es wurde wie in Beispiel 3 verfahren, nur daß nun eine Auswaschlösung aus 80 Vol.-Teilen Tetrachlorethylen und 20 Vol.-Teilen n-Butanol verwendet wurde. Die Versuche wurden in einem nicht explosionsgeschützten Wascher mit starker Absaugung (ca. 100 m³/h) durchgeführt.

Die optimale Auswaschzeit betrug 5 Minuten. Eine 100 %ige Überwaschung machte sich jetzt im Fehlen kritischer Testelemente (freistehende Punkte und Linien) und in Ausbrüchen an Rasterfeldern und Gittern bemerkbar.

Beispiel 4

An einer wie in Beispiel 1 hergestellten Flexodruckform vom Plattentyp 1 wurde der Trocknungsverlauf in Abhängigkeit von der Zeit in einem Umlufttrockenschrank bei 65°C ermittelt.

Direkt nach dem Auswaschen betrug die Gewichtsquellung 2 %. Nach einer Trocknungsdauer von 2 Stunden bei 65°C war die Gewichtsquellung auf -0,1 %, des Ausgangsgewichtes zurückgegangen. Der nach einer Trocknungsdauer von 24 Stunden ermittelte extrahierte Anteil betrug 0,3 %, bezogen auf das Ausgangsgewicht.

Vergleichsbeispiel 6

Es wurde wie in Beispiel 4 verfahren, nur wurde als Auswaschlösemittel eine Mischung aus 80 Vol.-Teilen Tetrachlorethylen und 20 Vol.-Teilen n-Butanol eingesetzt.

Direkt nach dem Auswaschen betrug die Gewichtsquellung 8 %. Nach einer Trocknungsdauer von 2 Stunden war die Gewichtsquellung zwar ebenfalls auf -0,1 %. zurückgegangen, der extrahierte Anteil betrug aber 1,7 %, bezogen auf das Ausgangsgewicht.

Beispiel 5

Als Flexodruckplatte wurde der Plattentyp 3 eingesetzt. Nach der rückseitigen Vorbelichtung wurde die Flexodruckplatte von der Vorderseite durch ein Testnegativ bildmäßig belichtet (Belichtungszeit 20 Minuten) und anschließend in einem Bürstenwascher zur Flexodruckform entwickelt. Als Auswaschlösung wurde eine Mischung aus 80 Vol.-Teilen einer hydrierten Erdölfraktion (Naphthengehalt 35 %, Paraffingehalt 65 %, Siedebereich 186 bis 217°C, Aromatengehalt <1 % nach DIN 51 378) und 20 Vol.-Teilen n-Butanol eingesetzt.

Die für eine Reliefhöhe von 700 µm optimale Auswaschzeit betrug 12 Minuten. Sämtliche Testelemente waren einwandfrei und korrekt ausgebildet. Nach der Nachbehandlung wurden Flexodruckformen erhalten, die eine gleichförmig glatte Oberfläche aufwiesen.

Vergleichsbeispiel 7

Es wurde wie in Beispiel 5 verfahren, nur wurde als Auswaschmittel eine Mischung aus 80 Vol.-Teilen Tetrachlorethylen und 20 Vol.-Teilen n-Butanol eingesetzt.

Die für eine Reliefhöhe von 700 µm optimale Auswaschzeit betrug wiederum 12 Minuten. An Kanten und in Rasterfeldern wurden Ausbrüche festgestellt. Nach der Nachbehandlung wurden Flexodruckformen, die eine ungleichmäßige, zerstörte Oberfläche aufwiesen.

EP 0 470 071 B1

Beispiel 6

Es wurde wie in Beispiel 1 verfahren, nur wurde als Auswaschlösung eine Mischung aus 75 Vol.-Teilen einer hydrierten Erdölfraktion (Siedebereich 160 bis 195°C, Naphthengehalt 35 %), 20 Vol.-Teilen n-Butanol und 5 Vol.-Teilen Limonen eingesetzt.

Die Auswaschversuche wurden an einem nicht explosionsgeschützten Bürstenwascher mit geringer Absaugung (ca. 10 m³/h) durchgeführt. Die optimale Auswaschzeit für ein 700 μm Relief betrug 5 Minuten. Die Flexodruckformen wiesen einen angenehmen orangenartigen Geruch auf.

**Patentansprüche**

1. Verfahren zur Herstellung von durch Photopolymerisation vernetzten Flexodruckformen durch bildmäßiges Belichten von durch Photopolymerisation vernetzbaren Schichten mit aktinischem Licht unter Vernetzung der belichteten Schichtanteile und Auswaschen der unvernetzten Anteile der Schichten mit Kohlenwasserstofflösungsmitteln oder Gemischen aus Kohlenwasserstofflösungsmitteln und Alkoholen, dadurch gekennzeichnet, daß die vernetzbaren Schichten als Bindemittel Vinylaromat/Alkadienblockmischpolymerisate, Alkadien/Acrylnitrilcopolymerisate oder Ethylen-Propylen-Dien-Terpolymere enthalten, und zum Auswaschen als Kohlenwasserstofflösungsmittel hydrierte Erdölfraktionen verwendet werden, die Flammpunkte >45°C und Siedebereiche zwischen 160 und 220°C aufweisen.

2. Verfahren nach Anspruch 1, dadurch gekennzeichnet, daß die hydrierte Erdölfraktion einen Aromatengehalt nach DIN 51 378 von <1 % aufweist.

3. Verfahren nach einem der vorhergehenden Ansprüche, dadurch gekennzeichnet, daß die hydrierte Erdölfraktion einen naphthenischen Anteil nach DIN 51 378 zwischen 0,5 und 50 % aufweist.

4. Verfahren nach einem der vorhergehenden Ansprüche, dadurch gekennzeichnet, daß die hydrierte Erdölfraktion einen Zusatz eines Geruchsverbesserers enthält.

5. Verfahren nach einem der vorhergehenden Ansprüche, dadurch gekennzeichnet, daß die hydrierte Erdölfraktion einen Zusatz eines oberflächenaktiven Stoffes enthält.

**Claims**

1. A process for preparing a flexographic printing plate, which is crosslinked by photopolymerization, by imagewise exposing a layer which can be crosslinked by photopolymerization to actinic light, with crosslinking of the exposed parts of the layers, and washing out the non-crosslinked parts of the layer with a hydrocarbon solvent or a mixture of a hydrocarbon solvent and an alcohol, wherein the crosslinkable layers contain, as binders, vinyl aromatic/alkadiene block copolymers, alkadiene/acrylonitrile copolymers or ethylene/propylene/diene terpolymers, and the hydrocarbon solvents used for washout are hydrogenated petroleum fractions which have flashpoints > 45°C and boiling ranges from 160 to 220°C.

2. A process as claimed in claim 1, wherein the hydrogenated petroleum fraction has an aromatics content of < 1%, according to DIN 51,378.

3. A process as claimed in any of the preceding claims, wherein the hydrogenated petroleum fraction contains from 0.5 to 50% of naphthenic compounds, according to DIN 51,378.

4. A process as claimed in any of the preceding claims, wherein the hydrogenated petroleum fraction contains an added odor improver.

5. A process as claimed in any of the preceding claims, wherein the hydrogenated petroleum fraction contains an added surface-active compound.

7

**EP 0 470 071 B1**

**Revendications**

1. Procédé de fabrication de formes d'impression flexographique réticulées par photopolymérisation, par exposition, selon une image, de couches réticulables par polymérisation à la lumière actinique avec réticulation des parties de couche exposées et enlèvement des parties de couche non réticulées par lavage avec des solvants hydrocarbures ou mélanges de solvants hydrocarbures et d'alcools, caractérisé par le fait que les couches réticulables contiennent comme liants des copolymérisats en blocs aromate de vinyle/alcadiène, des copolymérisats alcadiène/acrylonitrile ou des terpolymères éthylènepropylène-diène et, pour l'élimination par lavage, comme solvants hydrocarbures, sont utilisées des fractions d'huile minérale hydrogénées qui présentent des points d'inflammation supérieurs à 45°C et des points d'ébullition compris entre 160 et 220°C.

2. Procédé selon la revendication 1, caractérisé par le fait que la fraction d'huile minérale hydrogénée présente une teneur en aromates selon DIN 51 378 inférieure à 1 %.

3. Procédé selon l'une des revendications précédentes, caractérisé par le fait que la fraction d'huile minérale hydrogénée présente une portion naphténique selon DIN 51 378 comprise entre 0,5 et 50 %.

4. Procédé selon l'une des revendications précédentes, caractérisé par le fait que la fraction d'huile minérale hydrogénée contient un additif de connecteur d'odeur.

5. Procédé selon l'une des revendications précédentes, caractérisé par le fait que la fraction d'huile minérale hydrogénée contient un additif de produit tensioactif.

8